# FASCICULE DE BREVET EUROPEEN

(11) **EP 0 574 276 B1**
(45) Date de publication et mention de la délivrance du brevet: **11.06.1997**
(21) Numéro de dépôt: 93400927.5
(22) Date de dépôt: 08.04.1993
(51) Int. Cl.: B25H 3/02, H05K 5/02, H05K 7/14, G12B 9/02, H05K 9/00

(54) **Valise de contention et de transport de cartes électroniques ou autre petit matériel pour appareillage électronique**
Koffer für die Aufbewahrung und den Transport von elektronischen Leiterplatten oder anderem Kleinmaterial für elektronische Geräte
Suitcase for the storage and transport of electronic boards or other small material for electronic equipment

(30) Priorité: 10.04.1992 FR 9204427
(43) Date de publication de la demande: 15.12.1993
(73) Titulaire: ALCATEL RESEAUX D'ENTREPRISE, F-75015 Paris (FR)
(72) Inventeur: Noblet, Dominique, F-78700 Conflans Sainte Honorine (FR)
(74) Mandataire: Schaub, Bernard

(56) Documents cités:
- EP-A- 0 163 174
- EP-A- 0 375 925
- DE-A- 3 710 438
- DE-B- 2 445 792
- DE-U- 8 219 482
- FR-A- 2 266 425
- FR-A- 2 666 204
- GB-A- 2 228 921

## Description

La présente invention se rapporte à une valise de contention et de transport de cartes électroniques ou autre petit matériel pour appareillage électronique. Une telle valise est connue de l'art antérieur, par exemple, par le document EP-A-0 163 174.

Les appareils électroniques modernes sont composés d'un certain nombre de cartes interchangeables. Lorsqu'un appareil est en panne, il convient de changer la carte défectueuse qui a provoqué cette panne.

Dans ce but, chaque réparateur est en possession de cartes neuves ou réparées, qu'il prend à l'Agence Locale dont il dépend et emmène à l'avance dans son véhicule en fonction du ou des appareils à dépanner et du ou des pannes qui lui ont été signalées. Sur le site, il emporte une ou plusieurs de ces "bonnes" cartes afin, après test et diagnostic de la panne, pouvoir remplacer sur l'appareil la ou les cartes "mauvaises" par la ou les cartes "bonnes" correspondantes.

Ces cartes "mauvaises" sont ensuite acheminées par ses soins jusqu'à l'Agence Locale de télémaintenance précitée. Elles sont ensuite transportées jusqu'à un Centre de Télémaintenance Régional, qui centralise toutes les cartes provenant des diverses Agences Locales, et finalement de ce Centre de Télémaintenance Régional vers le Centre de Réparation du Service Après Vente.

Les cartes neuves ou réparées subissent les trajets inverses, partant de ce Centre de Réparation pour aboutir à l'Agence Régionale et finalement, par les soins du réparateur, chez le client ayant un appareil en panne.

En ce qui concerne le transport, le rangement, le stockage, et la manutention des cartes et autres matériels électroniques neufs ou réparés, il existe actuellement des normes de qualité en chaîne de ce matériel de maintenance, par exemple la norme ISO 9001.

Il convient en effet de s'assurer que, à partir du moment où ce matériel de maintenance est soit neuf, soit réparé, il ne puisse subir aucun dommage entre le lieu où il est émis et le moment où il arrive chez le client. Ces dommages peuvent, pendant tout ce parcours, être causés par des chocs, des vibrations , de l'électricité statique, etc ... Il doit en conséquence être emballé, transporté, rangé, stocké, dans des dispositifs de contention qui tous garantissent une bonne qualité en chaîne lors de toutes les opérations de transport, de rangement, manutention,..., qui jalonnent le parcours précité.

Actuellement, ces opérations sont le plus souvent effectuées par utilisation de caisses en carton, de pochettes plastiques, etc..., ce qui ne répond pas à la norme de qualité requise tout au long du parcours de ce matériel de maintenance.

L'invention vise à remédier à cet inconvénient. Elle se rapporte à cet effet à une valise de contention et de transport de cartes électroniques ou autre petit matériel pour appareillage électronique, cette valise étant constituée de quatre parties faciles à assembler et désassembler, toutes réalisées en matériau antistatique :
. un corps central en forme de parallélépipède de rectangle creux qui est ouvert sur sa petite face supérieure reçevant le couvercle de la valise, ce corps central étant pourvu d'organes de fixation de cartes ou autres matériels pour appareillage électronique,
. deux flancs latéraux qui sont prévus pour d'une part se fixer respectivement sur les deux grandes faces latérales de ce corps central, et pour d'autre part se fixer l'un sur l'autre pour constituer une mallette peu épaisse; et
. ledit couvercle de la valise qui est prévu pour se fixer sur le corps central.

Avantageusement, lesdits organes de fixation des cartes sont constitués par deux plaques en matériau antistatique, telle qu'une mousse conductrice des charges électriques, qui sont rapportées face à face sur la partie interne des deux petites faces latérales du corps central et qui comportent chacune deux jeux de rainures parallèles se croisant à angle droit, de façon à servir de de glissières d'enfichage de cartes (ou supports de même forme) soit pour l'introduction verticale de ces cartes ou supports dans la valise posée debout, soit à contrario pour l'introduction de ces cartes ou supports par une grande face latérale du corps central, prévue ouverte en conséquence, pour le stockage dans ce corps central, les cartes pouvant alors dépasser de ce dernier de sorte que leur identification et leur préhension s'en trouvent facilitées.

Avantageusement encore, un de ces deux flancs latéraux amovibles comporte un couvercle rabattable destiné à la mallette qui est réalisable par l'assemblage de ces deux flancs, ce couvercle rabattable se prolongeant par une poignée qui, en passant à l'horizontale dans une ouverture conjuguée prévue à la partie supérieure de l'autre flanc puis en étant relevée à la verticale, vient former la poignée de préhension de cette mallette, cette poignée se trouvant ainsi déportée sur un côté du couvercle de la mallette, ce qui permet de porter aisément d'une même main soit deux mallettes de ce type, soit une mallette et par exemple une sacoche d'outillage.

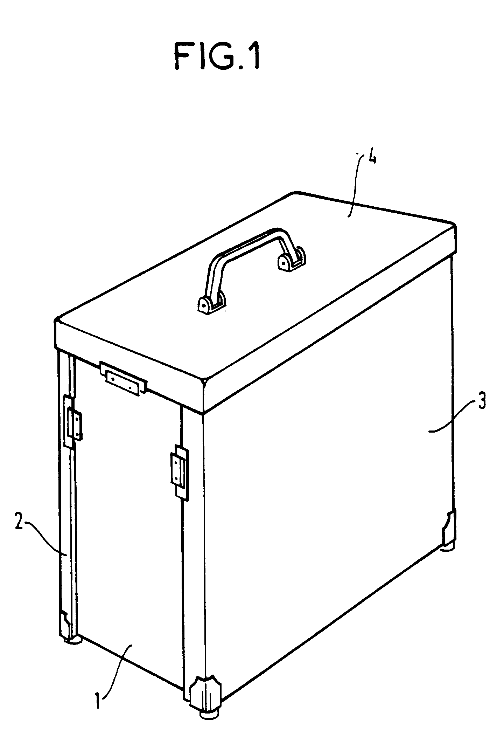

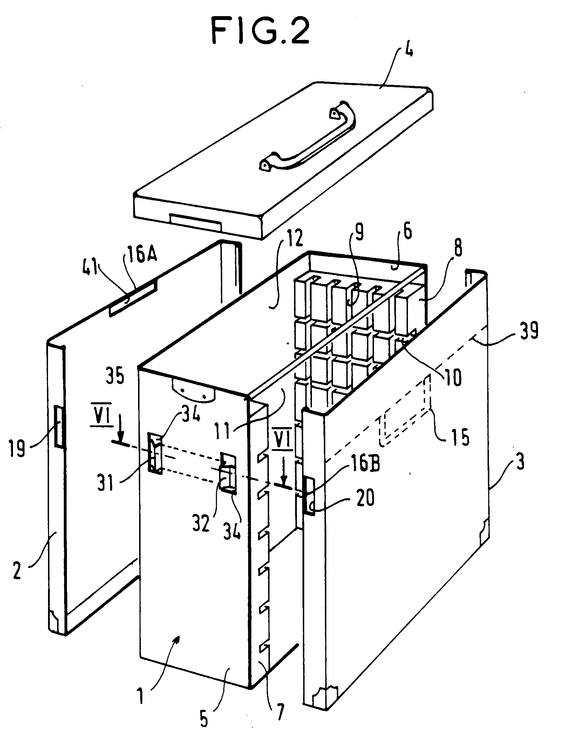

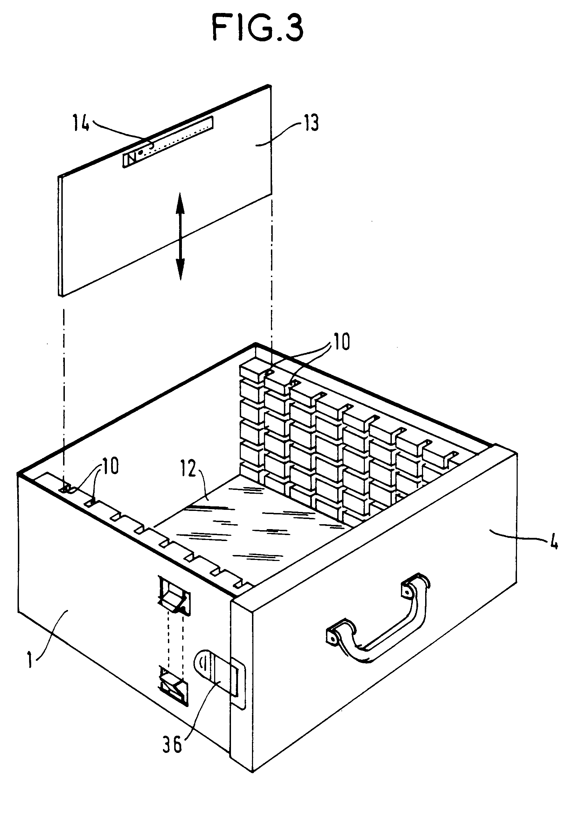

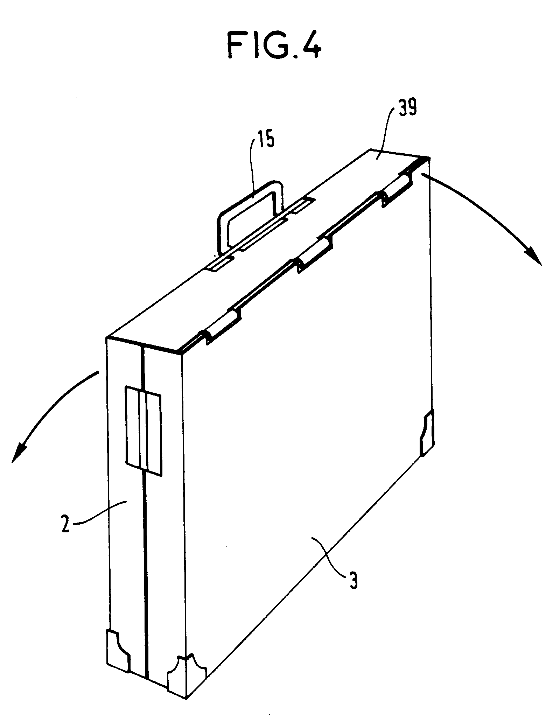

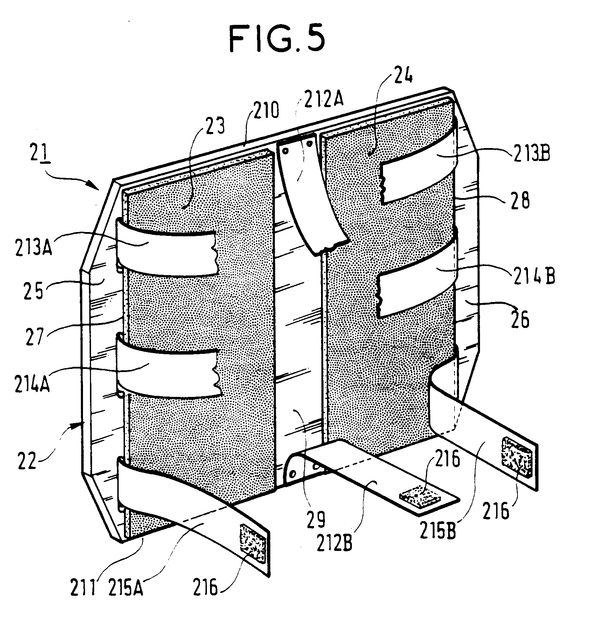

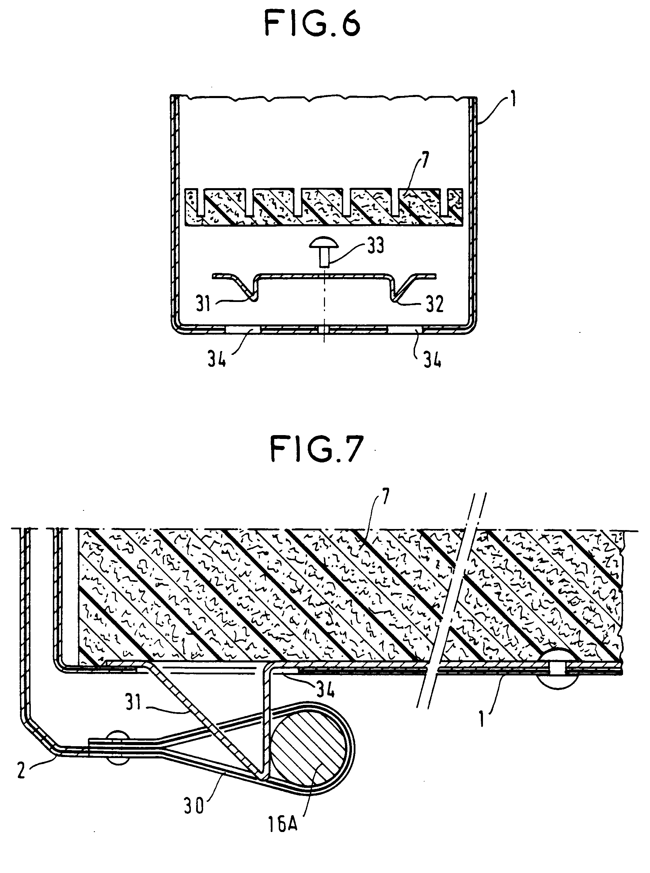

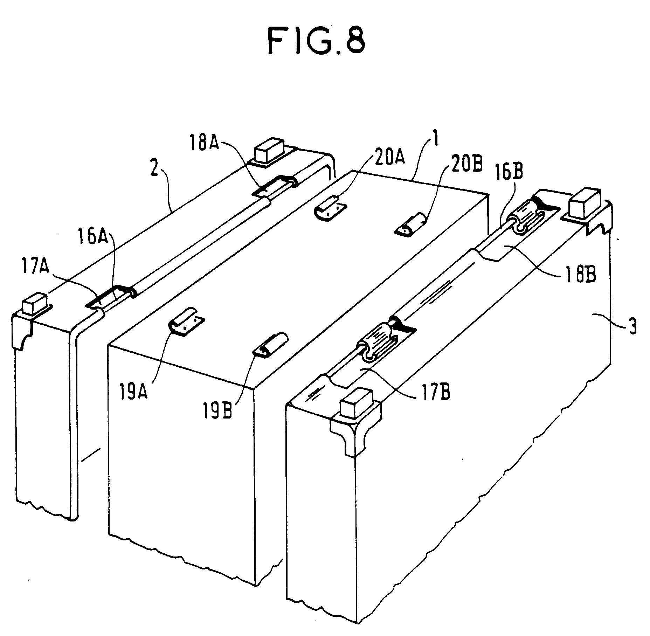

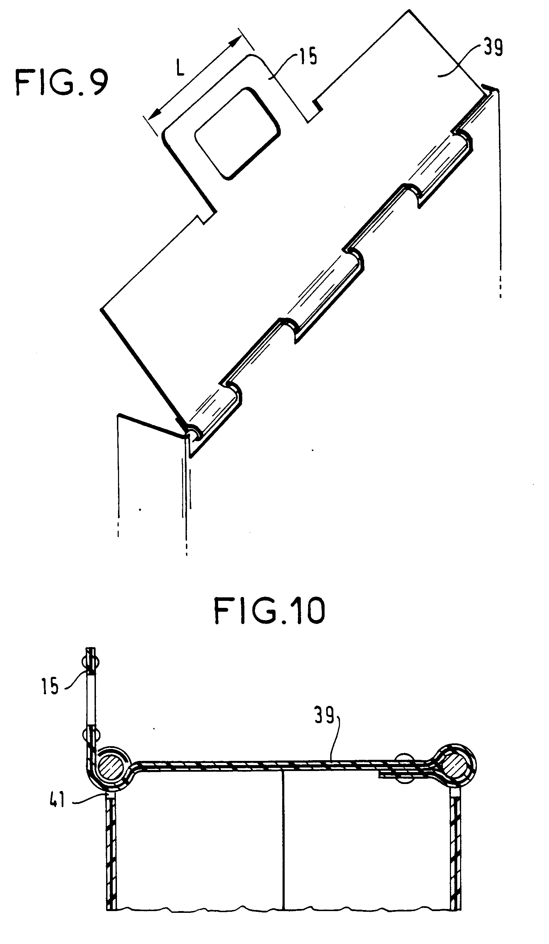

De toute façon, l'invention sera bien comprise, et ses avantages et autres caractéristiques ressortiront, lors de la description suivante d'un exemple non-limitatif de réalisation de cette valise multi-fonctions, en référence au dessin schématique annexé dans lequel :
. Figure 1 est une vue d'ensemble en perspective de cette valise de contention et de transport;
. Figure 2 en est une vue éclatée;
. Figure 3 schématise son utilisation comme tiroir de rangement de cartes électroniques ou éléments analogues;
. Figure 4 schématise son utilisation comme petite mallette de transport des cartes sur le site;
. Figure 5 montre un support universel de transport de cartes électroniques ou autres petits sous-ensembles électriques ou électroniques d'encombrement analogue, ce support étant conçu pour être enfiché dans cette valise;
. Figure 6 est une vue éclatée de détail, selon VI-VI de Figure 2, qui montre le positionnement d'une attache rapide de fixation des deux flancs latéraux de la valise sur son corps central;
. Figure 7 est une vue agrandie de cette attache rapide, avec un de ces deux flancs en position;
. Figure 8 est une vue en éclaté du dessous de cette valise, montrant les attaches inférieures de solidarisation de son corps central et de ses deux flancs latéraux amovibles; et
. Figures 9 à 13 montrent le mode d'assemblage, avec poignée, des deux flancs latéraux amovibles, pour créer une mallette selon Figure 4;

En se référant aux figures 1 et 2, cette valise multi-fonctions est composée d'un ensemble de quatre pièces séparables et réassemblables par attaches rapides :
. Un corps central creux 1 en forme de parallélépipède rectangle.
. Deux flancs latéraux 2,3 qui, comme on le verra ci-après, peuvent aussi être assemblés ensemble pour constituer une petite mallette peu épaisse du genre "attaché-case".
. Un couvercle 4.

Toutes ces pièces 1 à 4 sont réalisées en un matériau "antistatique", d'une résistance électrique ni trop grande ni trop petite, et plus précisément ils comprennent une âme métallique qui est revêtue d'une fibre légèrement conductrice fixée par rivetage, une telle fibre "antistatique" étant largement disponible dans le commerce.

Le corps central 1 est trés particulier. D'une part, il comporte, collées en vis-à-vis à l'intérieur de ses deux petites faces latérales 5,6, deux plaques 7,8 de mousse antistatique qui sont chacune striées de deux séries de rainures parallèles 9,10, ces deux séries se croisant à angle droit en forme globale de grille. Les grandes et petites rainures 9,10 sont conjuguées sur les deux plaques opposées 7 et 8 pour constituer des paires de glissières, "grandes" et "petites" respectivement, chacune de ces paires de glissières étant apte à recevoir une carte, ou support analogue tel que celui représenté en Figure 5.

Cette carte est normalement introduite dans les grandes rainures conjuguées 9 verticalement et du haut en bas, la valise étant supposée debout avec son couvercle 4 retiré.

D'autre part, ce corps central 1, s'il est bien-entendu ouvert sur le dessus et fermé en bas, est en outre ouvert sur l'une 11 de ses grandes faces latérales et fermé sur l'autre 12.

En première utilisation donc, prévue pour le transport et le stockage d'un nombre moyen de cartes (quatre cartes dans l'exemple représenté), la valise est toute assemblée comme en figure 1. La largeur des cartes correspond à celle séparant deux "grandes" rainures 9 conjuguées sur les plaques 7 et 8, c'est-à-dire est légèrement inférieure à la longueur de la valise. Les cartes neuves ou réparées sont par exemple enfichées dans la valise et dans les rainures 9 au Centre de Télémaintenance Régionale, puis le couvercle 4 est mis en place et cette valise fermée est transportée jusqu'à une Agence Régionale et ainsi stockée dans cette Agence. Un étiquetage est prévu sur une des petites faces latérales, 5 par exemple, pour savoir quelles sont les cartes placées dans cette valise.

Le technicien affecté à cette Agence Régionale prend, selon les appareils qu'il doit dépanner sur le ou les sites, une ou plusieurs de ces valises remplies de cartes neuves ou réparées, et la ou les transporte dans son véhicule.

Il procède alors à l'opération de rangement suivante, schématisée Figure 3, qui correspond à la deuxième utilisation de cette valise :

Après avoir vidé la valise de toutes ses cartes, il retire les deux flancs latéraux amovibles 2,3, puis il remet en place le couvercle 4 et pose l'ensemble 1,4 ainsi obtenu (figure 3) à plat sur le fond latéral plein 12 et dans le coffre de son véhicule. Il obtient ainsi un casier de rangement pour les cartes 13 qui sont alors enfichées debout dans les "petites" rainures 10, conjuguées en conséquence pour recevoir ces cartes.

Les cartes 13 dépassent généralement alors généreusement du tiroir 1,4, ce qui permet de lire aisément l'étiquetage 14 qui permet classiquement de les identifier.

Arrivé sur le site, le technicien prend dans ce tiroir une ou deux cartes supposées être les bonnes, et les range dans la mallette qui, selon Figure 4, résulte de l'assemblage des deux flancs latéraux 2,3 de la valise d'origine : ceci correspond à la troisième utilisation de cette valise. Cette mallette 2,3 lui sert donc sur place, là où il doit effectuer son dépannage.

A noter que, comme on l'expliquera ci-après en référence aux figures 9 à 11, la poignée 15 de cette mallette est, par construction, déportée sur le côté : ceci permet de transporter d'une main soit deux mallettes semblables, soit cette mallette et par exemple une sacoche d'outillage, l'autre main étant toujours utile pour ouvrir les portes.

En revenant aux figures 1 à 3, on a pris l'exemple d'une carte 13 de vraiment grandes dimensions. Pour transporter en sécurité soit des cartes de plus petite largeur que celle séparant deux rainures conjuguées 9 ou 10, soit d'autres éléments que des cartes qui peuvent équiper les appareils électroniques à dépanner, il est avantageux d'utiliser un support universel de transport tel que schématisé en figure 5 selon un schéma de principe non rigoureusement conforme dimensionnellement.

Comme on le voit sur cette figure 5,
ce dispositif de contention, ou support universel de transport 21, pour cartes électroniques ou analogues, se compose d'une plaque de base 22, en bois ou autre matériau antistatique, sur laquelle sont collées deux plaques de mousse antistatique 23,24.

La plaque de base 22 a une forme de rectangle, avec deux petits prolongements trapèzoïdaux 25 et 26 de part et d'autre des petits côtés 27,28 du rectangle. Cette plaque 22 est de faible épaisseur, par exemple de l'ordre de 0,5 cm pour fixer les idées.

Les deux plaques de mousse 23, 24 sont identiques, rectangulaires, peu épaisses (0,5 cm par exemple), et elles sont rapportées sur la plaque de bois 22 de façon à laisser entre elles une assez large et peu profonde rainure médiane 29 qui joint les deux grands côtés 210, 211 de la plaque rectangulaire 22.

Quatre paires de sangles élastiques de maintien des cartes sont prévues sur ce support universel 21 :
. Une première paire de sangles élastiques conjuguées 212A, 212B qui sont respectivement fixées, au niveau de la rainure médiane 29, sur les grands côtés 210, 211 de la plaque de base 22. Ces sangles sont de largeur légèrement inférieure à celle de la rainure 29 et d'épaisseur égale ou inférieure à la demi-profondeur de cette rainure, c'est à dire à la demi-épaisseur des plaques de mousse 23, 24.
. Trois autres paires de sangles élastiques conjuguées 213A,213B - 214A,214B - 215A,215B, qui sont orthogonales aux premières sangles 212A,212B, et qui sont respectivement fixées sur les petits côtés 27 et 28 du rectangle formé par la plaque de base 22.

Toutes ces sangles élastiques conjuguées ont leurs extrémités libres pourvues d'attaches rapides conjuguées, par exemple à "velours et crochets", qui permettent après tension de les fixer l'une à l'autre.

L'utilisation de ce support universel de transport 21 pour une carte électronique unique, pouvant être de dimensions relativement grandes, est la suivante :

Le support universel 21 est tout d'abord posé à plat avec toutes ses sangles 212A à 215B ouvertes.

Puis les deux sangles 212A et 212B sont rabattues tendues l'une sur l'autre et fixées dans cette position, de sorte qu'elles viennent ainsi pratiquement remplir la rainure médiane 29.

La carte électronique est alors posée à plat sur l'ensemble souple formé par les deux plaques de mousse 23, 24 et les deux sangles rabattues 212A, 212B, avec le côté "soudure" contenant les picots d'extrémités de têtes de composants posé sur cet ensemble : de la sorte, ces picots s'implantent dans la mousse et les sangles élastiques, ce qui constitue déjà une fixation mécanique protégeant la carte des vibrations et des chocs.

Les trois autres paires de sangles 213A à 215B sont alors rabattues tendues sur la carte et fixées l'une sur l'autre pour constituer un ensemble final rigide et prêt pour le transport, qui peut être enfiché, grâce aux prolongements 25 et 26 précités dans les couples de rainures 9 ou 10 précités du bloc central 1.

Ce même support universel 21 est aussi utilisable pour transporter deux cartes électroniques différentes dont la largeur est assez faible pour ne pas dépasser celle des plaques de mousse 23 et 24.

Dans ce cas, les cartes sont d'abord posées à plat et côte à côte sur le support 21, et plus précisément respectivement sur les plaques de mousse 23 et 24. Toutes les sangles 212A à 215B sont alors totalement ouvertes et, comme précédemment, les cartes sont posées sur la mousse 23, 24 par leur côté soudure, de sorte que les picots des composants viennent se fixer dans celle-ci.

Puis, les trois paires de sangles latérales conjuguées 213A à 215B sont rabattues, tendues, et fixées l'une sur l'autre. Le maintien des cartes n'est alors pas encore parfait puisqu'il reste entre elles un vaste espace libre qui ne procure aucun effet de maintien.

On rabat alors, tend, et fixe l'une sur l'autre les deux premières sangles conjuguées 212A et 212B, de sorte qu'ainsi les deux cartes sont maintenant fermement et distinctement enveloppées, et donc maintenues. Le support 21 peut alors être enfiché dans la valise.

A noter que lorsqu'on désire transporter dans la valise du matériel quelconque tout emballé, le support universel 21 peut être utilisé seul comme intercalaire pour caler ce matériel dans le conteneur et éviter ainsi qu'il se déplace au cours du transport.

Les systèmes d'assemblage rapide des éléments 1 à 4 de cette valise seront maintenant décrits en référence également aux figures 6 à 13.

Le système d'assemblage des deux flancs latéraux 2 et 3 sur le corps central 1 de la valise est visible sur les figures 2, 6, 7, et 8.

D'une manière générale, le pourtour libre de chacun des flancs latéraux 2 et 3 est constitué d'une solide tige métallique, respectivement 16A et 16B sur laquelle est rivetée la coque antistatique 30 (figure 7) du flanc latéral considéré.

Cependant, cette tige métallique n'est pas revêtue totalement par la coque antistatique: il est prévu un certain nombre d'ouvertures, en particulier :
. Deux ouvertures, respectivement 17A, 18A et 17B, 18B, sur la face de fond de la valise (figure 8). Ces quatre ouvertures coopèrent avec des pièces mâles courbes et conjuguées 19A, 20A et 19B, 20B qui sont fixées sur le fond du corps 1, pour assurer de manière amovible la solidarisation des parties inférieures du corps 1 et des flancs 2 et 3.
. Deux ouvertures latérales 19, 20 par flanc, qui sont situées (figure 2) environ aux trois quarts de la hauteur de la valise, et qui coopèrent en encliquetage avec deux "clips" métalliques élastiques 31, 32 qui sont rivetés (rivet 33, figures 6 et 7) sur le corps 1 et qui passent dans des ouvertures 34 prévues à cet effet dans ce corps 1.

Pour donc fixer les flancs 2 et 3 sur le corps central 1 de la valise, il faut donc (figure 8) tout d'abord introduire les tiges de fond 16A et 16B dans les pièces courbes de rétention complémentaires 19A, 20A et 19B, 20B, puis rabattre les deux flancs 2 et 3 contre le corps 1 pour solidariser par enclipsage les tiges latérales 16A et 16B (figure 2 et 7) avec les clips de retenue 31 et 32.

Bien entendu, la désolidarisation des éléments 1 à 3 s'effectue par les opérations successives inverses.

Le couvercle amovible 4 se fixe alors sur l'ensemble au moyen d'attaches rapides classiques 35 et 36, visibles respectivement sur les figures 2 et 4, qui sont prévues de manière classiquement conjuguée sur le corps 1 et ce couvercle 4.

Finalement, l'assemblage des deux flancs latéraux 2 et 3 pour obtenir la petite mallette dessinée en figure 4 s'effectue comme suit :

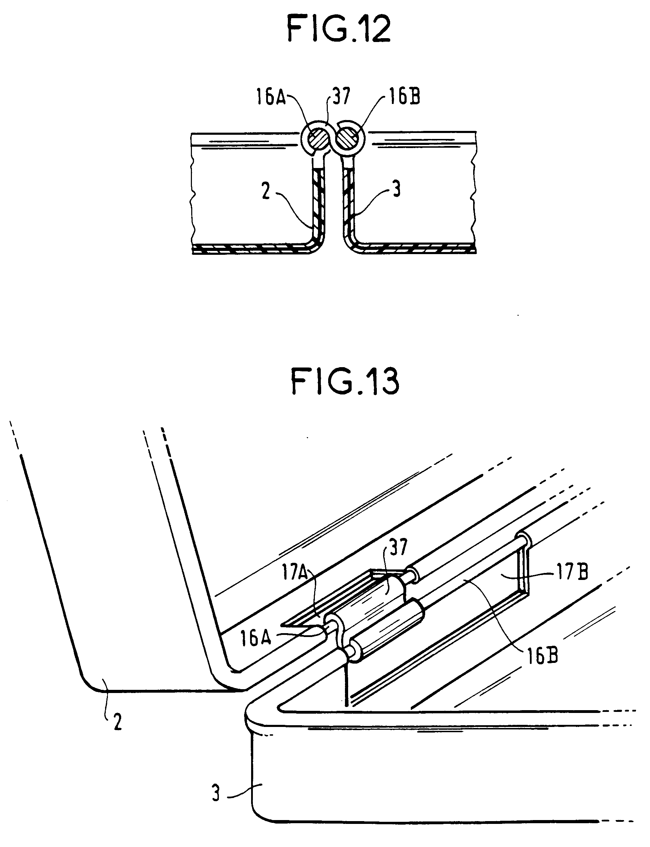

Comme on le voit sur les figures 8 et 13, les ouvertures 17b et 18B du fond du flanc 3 sont prévues environ deux fois plus longues que celles correspondantes, 17A et 18A, du fond du flanc 2. Ceci permet de garder "en réserve" une pièce coulissante 37 ( figure 8) en forme de S sur la tige 16B et dans chacune de ces plus longues ouvertures 17A et 17B. Ces deux pièces d'attache 37 ne sont pas utilisées lors de l'assemblage, selon Figure 8, des trois éléments 1, 2, et 3.

En revanche, selon Figure 13, ces pièces 37 sont ramenées, par coulissement latéral sur la tige 16B, au niveau des ouvertures 17A et 18A du flanc 2, puis basculées pour s'enclencher autour de la tige 16A, en solidarisant ainsi les faces inférieures des flancs 2 et 3 pour créer le fond de la petite mallette.

Dans la partie supérieure du flanc 3 est articulé un couvercle 39 ( figures 1, 9, et 10 ) qui se termine par une poignée 15. Ce couvercle 39 et cette poignée 15 sont normalement rabattus à plat ( figure 1 ) à l'intérieur du flanc 3.

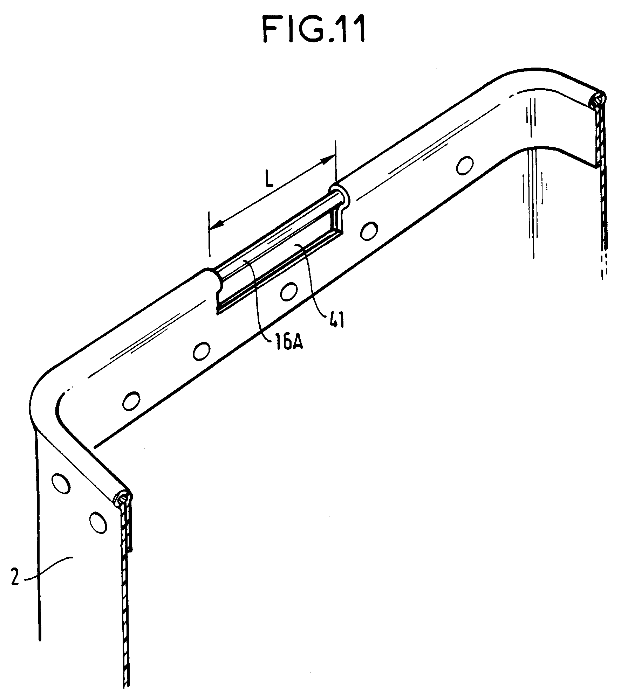

Il est en outre prévu ( figures 1 et 11 ) une ouverture 41 dans le haut du flanc 2, cette ouverture étant de largeur L légèrement supérieure, au jeu près pour permettre le passage aisé, à celle de la poignée plate 15.

Pour maintenant fermer la mallette, après l'assemblage décrit ci-dessus de son fond, on fait passer ( figure 10 ) la poignée 15 dans l'ouverture 41, puis on redresse cette poignée vers le haut comme représenté, ce qui se fait sans difficulté avec la matériau anti-statique semi-rigide utilisé. On obtient finalement ainsi la petite mallette représentée Figure 4, dont la poignée est avantageusement déportée sur le coté.

Comme il va de soi, l'invention n'est pas limitée à l'exemple de réalisation qui vient d'être décrit. Elle est bien au contraire susceptible d'être mise en oeuvre sous diverses formes, par utilisation de moyens équivalents, en particulier en ce qui concerne les systèmes d'attaches rapides qui peuvent être notablement différents.

## Revendications

1. Valise de contention et de transport de cartes électroniques ou autre petit matériel pour appareillage électronique, cette valise étant constituée de quatre parties faciles à assembler et désassembler, toutes réalisées en matériau anti-statique :
. un corps central (1) en forme de parallélépipède de rectangle creux qui est ouvert sur sa petite face supérieure reçevant le couvercle (4) de la valise, ce corps central étant pourvu d'organes (7, 8) de fixation de cartes ou autres matériels pour appareillage électronique,
. deux flancs latéraux (2, 3) qui sont prévus pour d'une part se fixer respectivement sur les deux grandes faces latérales de ce corps central, et pour d'autre part se fixer l'un sur l'autre pour constituer une mallette peu épaisse; et
. ledit couvercle (4) de la valise qui est prévu pour se fixer sur le corps central (1).

2. Valise multi-fonctions selon la revendication 1, caractérisée en ce que lesdits organes de fixation des cartes sont constitués par deux plaques (7,8) en matériau anti-statique, telle qu'une mousse conductrice des charges électriques, qui sont rapportées face à face sur la partie interne des deux petites faces latérales (5,6) du corps central (1) et qui comportent chacune deux jeux (9,10) de rainures parallèles se croisant à angle droit, de façon à servir de glissières d'enfichage de cartes (13), ou supports (21) de même forme, soit pour l'introduction verticale de ces cartes (13) ou supports (21) dans la valise posée debout, soit à contrario pour l'introduction de ces cartes ou supports par une grande face latérale (11) du corps central (1), prévue ouverte en conséquence, pour le rangement dans ce corps central (1), les cartes (13,21) pouvant alors dépasser de ce dernier de sorte que leur identification (14) et leur préhension s'en trouvent facilitées..

3. Valise multi-fonctions selon la revendication 1 ou la revendication 2, caractérisée en ce qu'un (3) de ces deux flancs latéraux amovibles comporte un couvercle rabattable (39) destiné à la mallette qui est réalisable par l'assemblage de ces deux flancs (2,3), ce couvercle rabattable se prolongeant par une poignée (15) qui, en passant à l'horizontale dans une ouverture conjuguée (41) prévue à cet effet à la partie supérieure de l'autre flanc (2) puis en étant relevée à la verticale, vient former la poignée de préhension de cette mallette (2,3), cette poignée (15) se trouvant ainsi déportée sur un côté du couvercle (39) de la mallette, ce qui permet de porter aisément d'une même main soit deux mallettes de ce type, soit une mallette et par exemple une sacoche d'outillage.

4. Valise multi-fonctions selon l'une des revendications 1 à 3, caractérisée en ce qu'elle est conçue pour recevoir un ou plusieurs dispositifs de contention (21) à caractère universel pour cartes électroniques ou autres petits sous-ensembles électriques ou électroniques d'encombrement analogue, ci-après tous appelés "cartes", ce dispositif de contention (21) comportant une plaque de base (22) en matériau antistatique tel que du bois, d'allure générale rectangulaire et de dimensions supérieures à celles d'une grande carte, au moins deux plaques de mousse antistatique (23,24) étant rapportées sur cette plaque de base (22) de façon à laisser entre elles-deux une rainure (29) sensiblement médiane et reliant deux côtés opposés (210,211) du rectangle, cette rainure (29) étant de largeur suffisante pour recevoir à plat une ou deux premières sangles élastiques (212A,212B) à fermeture rapide qui sont respectivement fixées sur ces côtés opposés (210,211) de la plaque de base, au moins deux autres sangles ou paires de sangles de même type (213A,213B, 214A,214B, 215A,215B), mais orthogonales aux premières (212A,212B), étant par ailleurs fixées sur les deux autres côtés opposés (27,28) de cette plaque de base (22), de sorte que :
. pour maintenir une seule carte, en principe de grandes dimensions, lesdites premières sangles (212A,212B) sont tout d'abord rabattues sur la plaque de base (22) en venant ainsi pratiquement remplir ladite rainure médiane (29), ensuite de quoi la carte est posée à plat sur la mousse (23,24) du côté "soudure" qui comporte les extrémités des queues de ses composants, et lesdites autres sangles (213A à 215B) sont alors rabattues, tendues et refermées sur cette carte;
. pour à contrario maintenir deux cartes éventuellement dissemblables et de dimensions suffisamment petites pour qu'elles tiennent côte-à-côte et à plat sur la mousse (23,24), ces deux cartes sont tout d'abord posées à plat sur cette mousse, côte-à-côte de part et d'autre de ladite rainure sensiblement médiane (29), toujours du côté "soudure" et avec lesdites premières sangles (212A,212B) ouvertes, ensuite de quoi lesdites autres sangles (213A à 215B) sont rabattues, tendues et refermées, puis enfin ces premières sangles (212A,212B) sont rabattues, tendues et refermées sur ces autres sangles (213A à 215B), ce qui finalement maintient distinctement et fermement ces deux cartes contre la mousse (23,24).

5. Valise multi-fonctions selon la revendication 4, caractérisée en ce que ladite plaque de base (22) comprend deux prolongements latéraux (25, 26) aptes à s'enficher dans lesdites rainures (9,10) du corps central (1) de la valise.

## Claims

1. A case for containing and transporting electronic cards or other small items for electronic equipment, the case being constituted by four portions which are easy to assemble and to disassemble, all four portions being made of an antistatic material, the four portions being:
a central body (1) in the shape of a hollow rectangular block which is open over its top small face receiving the case cover (4), the central body being provided with card-fixing members (7,8) for fixing cards or other items for electronic equipment;
two side panels (2,3) which are organized firstly so that they can be respectively fixed on the two large side faces of the central body, and secondly so that they can be fixed together to constitute a thin "briefcase"; and
said case cover (4) which is organized so that it can be fixed onto the central body (1).

2. A multi-purpose case according to claim 1, characterized in that said card-fixing members are constituted by two slabs (7, 8) made of an antistatic material such as a foam that conducts electric charges, which slabs are attached facing each other to the insides of the two small side faces (5, 6) of the central body (1), and each slab includes two sets (9, 10) of parallel grooves intersecting one another at right angles so as to serve as guide channels for slotting in cards (13), or similarly shaped supports (21), so that the cards (13) or supports (21) are either inserted vertically into the case when it is stood upright, or else inserted via one of the large side faces (11) of the central body (1), which large side face is consequently organized to be open so that the cards or supports can be arranged in the central body (1), the cards (13, 21) then being able to stand proud therefrom so that it is easier to identify (14) them and to take hold of them.

3. A multi-purpose case according to claim 1 or 2, characterized in that one (3) of the two removable side panels includes a hinged cover (39) for the briefcase which can be made by assembling the two panels (2, 3) together, the hinged cover being extended by a handle (15) which forms the carrying handle of the briefcase (2, 3) by being laid horizontal and passed through a corresponding opening (41) provided for this purpose in the top of the other panel (2), and then being stood vertical, the handle (15) thus being offset to one side of the cover (39) of the briefcase, thereby making it possible either for two briefcases of this type, or for one such briefcase and, for example, a tool bag to be carried easily in the same hand.

4. A multi-purpose case according to any one of claims 1 to 3, characterized in that it is designed to receive one or more jigs (21) for containing a variety of electronic cards or other small electrical or electronic sub-assemblies of analogous size, all referred to below as "cards", said jig (21) including a base-plate (22) made of an antistatic material such as wood, rectangular in overall appearance, and having dimensions greater than the dimensions of a large card, at least two sheets made of antistatic foam (23, 24) being attached to the base-plate (22) such that a gap (29) is left between them, which gap is substantially in the middle and interconnects two opposite sides (210, 211) of the rectangle, the gap (29) being wide enough to receive one or two first resilient straps (212A, 212B) laid flat, which straps are fixed respectively to said opposite sides (210, 211) of the base-plate and have quick-fastening means, at least two other straps or pairs of straps of the same type (213A, 213B; 214A, 214B; 215A, 215B), but orthogonal to the first straps (212A, 212B), further being fixed to the two other opposite sides (27, 28) of the base-plate (22), so that:
in order to hold a single card, that is in principle a large card, firstly said first straps (212A, 212B) are folded down on the base-plate (22), thereby practically filling said middle gap (29), after which the card is placed flat on the foam (23, 24) and lying on its "soldered" side which includes the ends of the leads of the components of the card, and said other straps (213A to 215B) are then folded down, tightened together, and closed on said card; and
in order to hold two cards that are optionally dissimilar and have dimensions small enough for the two cards to fit side-by-side and flat on the foam (23, 24), firstly the two cards are placed flat on the foam, side-by-side, on either side of said substantially middle gap (29), also lying on their "soldered" sides, and with said first straps (212A, 212B) open, after which said other straps (213A to 215B) are folded down, tightened together, and closed, and then the first straps (212A, 212B) are folded down, tightened together, and closed on the other straps (213A to 215B), thereby finally holding both cards separately and firmly against the foam (23, 24).

5. A multi-purpose case according to claim 4, characterized in that said base-plate (22) includes two side extensions (25, 26) suitable for being slotted into said grooves (9, 10) in the central body (1) of the case.

## Patentansprüche

1. Koffer zur Unterbringung und zum Transport von elektronischen Karten oder anderen Kleinbauteilen für elektronische Geräte, wobei der Koffer aus vier leicht zusammensetzbaren und zerlegbaren Teilen besteht, die alle aus antistatischem Material gebildet werden, nämlich:
. einem zentralen Körper (1) in Form eines geraden, hohlen Parallelepipeds, der auf seiner oberen kleinen Seite zur Aufnahme eines Kofferdeckels (4) offen ist und mit Organen (7, 8) zur Befestigung von Karten oder anderen Kleinteilen für elektronische Geräte versehen ist,
. zwei Seitenteilen (2, 3), die einerseits an den beiden großen Seitenflächen des zentralen Körpers und andererseits aneinander befestigt werden können, um einen weniger dicken Handkoffer zu bilden,
. und dem Deckel (4) des Koffers, der auf dem zentralen Körper (1) befestigt werden kann.

2. Multifunktionskoffer nach Anspruch 1, dadurch gekennzeichnet, daß die Befestigungsorgane für Karten aus zwei Platten (7, 8) aus antistatischem Material wie z.B. einem elektrisch Ladungen leitenden Schaum bestehen, die einander gegenüberliegend auf der Innenwand der beiden kleinen Seitenflächen (5, 6) des zentralen Körpers (1) angebracht sind und je zwei sich rechtwinklig schneidende Sätze von parallelen Rillen (9, 10) enthalten, die als Gleitschienen zum Einstecken von Karten (13) oder Trägern (21) gleicher Form dienen, und zwar entweder für das senkrechte Einstecken dieser Karten (13) oder Träger (21) in den senkrecht stehenden Koffer oder im Gegensatz dazu zum Einstecken der Karten oder Träger in den dann entsprechend offenen zentralen Körper (1) über eine von dessen großen Seiten (11), wobei die Karten (13, 21) dann über diesen so vorstehen können, daß ihre Identifizierung (14) und ihr Ergreifen erleichtert wird.

3. Multifunktionskoffer nach Anspruch 1 oder 2, dadurch gekennzeichnet, daß eines der beiden abnehmbaren Seitenteile (3) einen umklappbaren Deckel )(39 aufweist, der für den Handkoffer bestimmt ist, welcher sich beim Zusammenfügen der beiden Seitenteile (2, 3) ergibt, wobei dieser umklappbare Deckel durch einen Handgriff (15) verlängert wird, der, nachdem er waagrecht durch eine entsprechende Öffnung (41) im oberen Bereich des anderen Seitenteils (2) gesteckt und dann in die Senkrechte angehoben wurde, den Haltegriff des Handkoffers (2, 3) bildet und auf einer Seite des Deckels (39) des Handkoffers versetzt angeordnet ist, wodurch es möglich wird, entweder zwei derartige Handkoffer oder einen Handkoffer und beispielsweise einen Werkzeugkoffer mit einer Hand zu tragen.

4. Multifunktionskoffer nach einem der Ansprüche 1 bis 3, dadurch gekennzeichnet, daß er einen oder mehrere Universalbehälter (21) für elektronische Karten oder andere kleine elektrische oder elektronische Untereinheiten ähnlicher Abmessungen aufnehmen kann, die nachfolgend alle mit "Karten" bezeichnet werden, daß der Universalbehälter (21) eine Basisplatte (22) aus antistatischem Material wie z.B. Holz mit allgemein rechteckiger Form und größeren Abmessungen als eine "große" Karte enthält, daß mindestens zwei antistatische Schaumstoffplatten (23, 24) auf diese Basisplatte (22) so aufgebracht sind, daß zwischen ihnen eine im wesentlichen zentrale und zwei gegenüberliegende Kanten (210, 211) des Rechtecks miteinander verbindende Rille (29) verbleibt, deren Breite ausreicht, um einen oder zwei erste elastische Gurte (212A, 2121B) mit Schnellverschluß aufzunehmen, die je an einem gegenüberliegenden Rand (210, 211) der Basisplatte befestigt sind, und daß mindestens zwei weitere Gurte oder Paare von Gurten gleichen Typs (213A, 213B; 214A, 214B; 215A, 215B) senkrecht zu den ersten Gurten (212A, 212B) an den beiden anderen gegenüberliegenden Rändern (27, 28) der Basisplatte (22) befestigt sind, so daß
. zum Halt einer einzigen Karte mit "großen" Abmessungen die ersten Gurte (212A, 212B) zuerst auf die Basisplatte (22) umgeschlagen werden und dann praktisch die Mittelrille (29) füllen und dann die Karte flach mit der Lötseite, die die Enden der Anschlußdrähte der Bauelemente enthält, auf den Schaumstoff (23, 24) gelegt wird, worauf schließlich die anderen Gurte (213A bis 215B) auf diese Karte umgeschlagen, gespannt und geschlossen werden,
. für die Befestigung von zwei gegebenenfalls unterschiedlichen Karten ausreichend kleiner Abmessungen, so daß sie nebeneinander flach auf dem Schaumstoff (23, 24) Platz finden, diese beiden Karten zuerst flach auf den Schaumstoff nebeneinander zu beiden Seiten der im wesentlichen mittleren Rille (29) wieder mit der Lötseite auf den Schaumstoff gelegt werden, wobei die ersten Gurte (212A, 212B) offen sind, worauf die anderen Gurte (213A bis 215B) umgeschlagen, gespannt und geschlossen werden, und schließlich die ersten Gurte (212A, 212B) ebenfalls, und zwar über die anderen Gurte (213A bis 215B) umgeschlagen, gespannt und verschlossen werden, wodurch schließlich die beiden Karten getrennt und fest auf dem Schaumstoff (23, 24) gehalten werden.

5. Multifunktionskoffer nach Anspruch 4, dadurch gekennzeichnet, daß die Basisplatte (22) zwei seitliche Verlängerungen (25, 26) aufweist, mit denen diese Platte in die Rillen (9, 10) des zentralen Körpers (1) des Koffers eingesteckt werden können.
